(19) Europäisches Patentamt
European Patent Office
Office européen des brevets

(11) **EP 2 579 056 B1**

(12) **EUROPEAN PATENT SPECIFICATION**

(45) Date of publication and mention of the grant of the patent:
**27.11.2024 Bulletin 2024/48**

(21) Application number: **11789286.9**

(22) Date of filing: **24.05.2011**

(51) International Patent Classification (IPC):
**G01R 31/52** (2020.01)     **G01R 31/12** (2020.01)

(52) Cooperative Patent Classification (CPC):
**G01R 31/1263;** G01R 31/1272

(86) International application number:
**PCT/ES2011/000168**

(87) International publication number:
**WO 2011/151480 (08.12.2011 Gazette 2011/49)**

(54) **NOVEL METHOD FOR REAL TIME TESTS AND DIAGNOSIS OF THE SOURCES OF PARTIAL DISCHARGE IN HIGH VOLTAGE EQUIPMENT AND INSTALLATIONS, WHICH ARE IN SERVICE OR NOT IN SERVICE, AND PHYSICAL SYSTEM FOR THE PRACTICAL USE OF THE METHOD**

NEUARTIGES VERFAHREN FÜR ECHTZEITTEST UND DIAGNOSE DER QUELLEN EINER PARTIKELENTLADUNG IN HOCHSPANNUNGSUMGEBUNGEN UND -INSTALLATIONEN IN ODER AUSSER BETRIEB SOWIE PHYSIKALISCHES SYSTEM ZUR PRAKTISCHEN AUSFÜHRUNG DIESES VERFAHRENS

NOUVEAU PROCÉDÉ POUR ANALYSER ET DIAGNOSTIQUER EN TEMPS RÉEL LES SOURCES DE DÉCHARGES PARTIELLES QUI SE PRODUISENT DANS DES APPAREILS ET DES INSTALLATIONS HAUTE TENSION EN SERVICE OU HORS SERVICE ET SYSTÈME PHYSIQUE CORRESPONDANT POUR L'APPLICATION PRATIQUE DUDIT PROCÉDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2010 ES 201000713**

(43) Date of publication of application:
**10.04.2013 Bulletin 2013/15**

(73) Proprietor: **Universidad Politécnica De Madrid (UPM)**
**28040 Madrid (ES)**

(72) Inventors:
• **GARNACHO VECINO, Fernando**
  **E-28040 Madrid (ES)**
• **SANCHEZ-URAN GONZALEZ, Miguel Angel**
  **E-28040 Madrid (ES)**
• **ORTEGO LA MONEDA, Javier**
  **E-28040 Madrid (ES)**

(74) Representative: **AWA Benelux**
**Parc d'affaires Zénobe Gramme - Bât. K**
**Square des Conduites d'Eau 1-2**
**4020 Liège (BE)**

(56) References cited:
**EP-A1- 0 627 085     EP-A2- 1 094 324**
**EP-B1- 0 627 085     ES-T3- 2 247 759**
**JP-A- 2003 075 501     JP-A- H11 248 783**
**US-A1- 2008 027 663     US-B1- 6 192 317**

• **X. MA ET AL: "Interpretation of wavelet analysis and its application in partial discharge detection", IEEE TRANSACTIONS ON DIELECTRICS AND ELECTRICAL INSULATION, vol. 9, no. 3, 1 June 2002 (2002-06-01), pages 446 - 457, XP055118941, ISSN: 1070-9878, DOI: 10.1109/TDEI.2002.1007709**

- JEROEN VEEN: "On-line Signal Analysis of Partial Discharges in Medium-Voltage Power Cables", TECHNISCHE UNIVERSITEIT EINDHOVEN, 2005, XP055118939, Retrieved from the Internet <URL:http://web.archive.org/web/20060320181825/http://alexandria.tue.nl/extra2/200511099.pdf> [retrieved on 20111205]
- X.MA,C.ZHOU ET AL.: "Interpretation of wavelet analysis and its application in partial discharge detection", IEEE TRANSACTIONS ON DIELECTRICS AND ELECTRICAL INSULATION., vol. 9, no. 3, June 2002 (2002-06-01), XP055118941, Retrieved from the Internet <URL:http://ieeexplore.ieee.org/xpls/abs_all.jsp?arnumber=1007709&tag=1>
- BOCZAR.,T. ET AL.: "Application of wavelet analysis to acoustic emission pulses generated by partial discharges", IEEE TRANSACTIONS ON DIELECTRICS AND ELECTRICAL INSULATION., vol. 11, no. 3, June 2004 (2004-06-01), XP055118942, Retrieved from the Internet <URL:http://ieeexplore.ieee.org/xpls/abs_all.jsp?arnumber=1306722>

## Description

### Object of the Invention

The present invention relates to a new diagnostic method for diagnosis of partial discharges (PDs) which complements the methods and systems for the continuous monitoring of (PDs) permanently installed in high voltage equipment or installations and consuming longer calculation time periods for analysing the measurements. The new invention reduces the analysis time, which allows performing real time diagnoses of the insulation condition of high voltage equipment and installations. Additionally, the new invention allows performing the diagnosis either by using the high voltage power grid itself (measurements in service) or with a novel voltage source designed therefor (measurements out of service) as a voltage source. The term high voltage equipment must be understood as a voltage and/or alternating or direct current generator, power transformer, voltage and/or current measurement and/or protection transformer, control switchgear, insulators and surge arresters, and the term high voltage installation must be understood as: high voltage cable systems with their junction and termination accessories, gas-insulated transmission lines, gas-insulated sub-stations and a metal-enclosed high voltage switchgear assembly.

The new method proposed by the present invention improves the processing time of the measured signals and achieves identifying the different focal points of PDs existing in the measured installation. It additionally includes a novel system for generating a high test voltage suitable for applying the new method when the grid voltage is not used (measurements out of service).

### Background and Summary of the Invention

The measurement of partial discharges has proven to be the most effective method for the diagnosis of the high voltage insulation equipment, machines and installations, such as measurement and protection transformers, switchgear, power transformers and reactors, alternators, gas-insulated sub-stations, cables with their installed accessories and gas-insulated lines.

A "partial discharge" must be understood in the context of this document as an electric discharge affecting a limited part of the insulation where it is produced, without causing its immediate failure, but its progressive degradation, except in the case of ambient air which is renewed naturally.

The practical difficulties in partial discharge measurements in equipment and installations proposed to be solved by the present invention are:

- On one hand, the high calculation and analysis time consumption which powerful and complex numerical tools require for applying the mathematical algorithms for discriminating the interfering electric noise masking the electric PD signals due to defects in the high voltage insulation.
- On the other hand, the difficulty in identifying and discriminating the total number of the PD sources for the purpose of separating them from one another and being able to identify each of them with the defect originating it.
- And finally, the difficulty in generating high test voltages with alternating voltage waveforms of the same frequency as the grid service frequency (50 Hz or 60 Hz) without requiring large volume and heavy generators.

Document EP 1 094 324 A2 discloses a method and an arrangement for determining the location of partial discharge sources in an electric system, the method comprising the steps of measuring a variable of the electric system, such as voltage or current, to which partial discharges occurring in the electric system cause pulses, separating the pulses caused by partial discharges, i.e. partial discharge pulses, and occurring in the measured variable, defining one or more characteristic parameters depicting the properties of partial discharge pulses for each partial discharge pulse after at least a predefined number of partial discharge pulses has been obtained, and determining the location of the partial discharge source by placing the obtained characteristic parameters in a model formed in advance, which depicts the dependency of the values of the characteristic parameters from the distance between the partial discharge source and the measuring point where the characteristic parameters have been defined on the basis of the measured variables.

The current techniques applied for real time PD measurements performed in the field relate to solving some of these problems in a different manner, but with serious limitations, as explained below:

a) Problems in real time electric background noise discrimination:

Most known methods treat the electric background noise problem by means of filtering the recorded signal in a frequency band in which the noise is presumably located. Filtering is sometimes performed for selective frequencies in a narrow frequency band.

It must be pointed out that the very conception of this filtering technique removes or attenuates the noise together with the PD signal for the filtered frequency range.

Another known method analyses the frequency spectrum of the noise signal for the purpose of choosing a measurement frequency band where the amplitude of the noise is the lowest possible amplitude. The drawback of this method is that sometimes the smallest noise signal band coincides with the band where the PD signal is also weak in amplitude, so PD measurement is difficult.

Another method which relates to removing noise by means of classifying the recorded signals (PDs + noise) into clusters is also known. The clusters are formed by means of determining parameters associated with the signal shape (duration and frequency) and its amplitude. The specific drawback of this method is that the processing is performed by signal level, such that to assure the capture of PD signals the acquisition level must be reduced, and therefore the noise signal content considerably increases. Processing becomes very laborious because the noise is put together with the PDs.

None of these methods is efficient for white noise, the spectrum of which covers all the frequencies of the PD signal. Frequency filtering techniques cannot be applied because the PD signal would also be lost, and a noiseless frequency band cannot be chosen either because there is a noise signal in all of them and PD clusters having a frequency different from that of the noise cannot be distinguished either.

An efficient technique for white noise is to apply the Wavelet transform of the recorded signal and statistically analysing its components in order to find transient events characteristic of PD pulses which are distinguished from the statistical evolution of the electric noise. The huge drawback of this technique for real time measurements is the high numerical processing time consumption of the recorded signals for discriminating noise from the PDs.

In the proposal of the new invention, noise is removed by applying the Wavelet transform to the recorded signal and statistically analysing its components for the purpose of finding events characteristic of PD pulses. The problem of the high processing time consumption required by this method is sought to be solved by means of multiple signal processing. High computing devices developed for personal computers, such as for example graphics cards having several multiprocessor units (GPGPU, General-Purpose Computing on Graphics Processing Units) allow drastically reducing calculation times, making the application of this powerful analysis technique to real time diagnostics viable. b) Problem with identifying and discriminating different PD sources:

Most known methods relate to identifying and discriminating the total number of PD sources through locating PD pulses, for example for locating PDs in a cable, the theory of wave propagation through a cable is used, either by using the reflectometry technique or by using the technique of arrival time delays of one and the same PD signal to two or more sensors distributed along the length of the cable.

The efficacy of these methods for identifying and discriminating different PD sources is limited by the uncertainty in the location of the PD source, which can be a few meters, such that it is impossible to assure that there is only one PD source in a specific location (for example in a cable termination accessory), one PD source being able to mask others located nearby. This is particularly critical when the predominating PD source is associated with a danger-free phenomenon, such as for example corona in air, other PD sources co-existing close to it having a smaller amplitude but a higher risk of failure, such as defects inside the insulation for example.

Some techniques use the phase displacement of the PDs in relation to the applied voltage for identifying different PD sources. Characteristic phase resolved PD patterns in phase of the test voltage, which are referred to as reference PD patterns, are known to be produced as a function of the type of defect (cavity inside the insulation, surface discharge in dirty or faulty insulations, corona effect in air in sharp-pointed conductive parts, etc.). If the measured pattern is compared with the reference patterns, it is possible to observe whether there is a single defect or several defects. However, when there are several defects, their corresponding patterns can overlap and be easily confused with one another, without it being easy to identify each and every one of them, the operator's experience being crucial for a correct diagnosis. Additionally, the noise not removed in many commercial techniques makes the identification of different PD sources through the simple visual observation of their patterns of PDs even more difficult.

Another more advanced technique establishes PD clusters as a function of two shape parameters of each PD pulse: pulse duration and pulse oscillation frequency. However, the shape of the PD signal can be very different as a function of the rise time and fall time of the PD pulse envelope, even though the PD signal has the same total duration and the same oscillation frequency.

The proposal of the new invention relates to solving this problem by characterizing the shape of the PD pulse by means of three parameters instead of two: parameter correlated with the front time of the envelope of the pulse, parameter correlated with the fall time of the envelope of the pulse and parameter correlated with the pulse oscillation frequency. The degree of discrimination of different PD clusters, particularly when there are a number of pulses to be distinguished having a similar duration, is improved with this technique.

c) Problem with generating high test voltages having the same frequency as the grid voltage for PD measurement in large installations:

Many generating systems used for testing large high voltage installations, such as for example cables several kilometres long, generate high test voltages with waveforms that are very different from the waveform of the service voltage in the power grid where the equipment operates (sinusoidal alternating voltage of 50 Hz or 60 Hz) for the purpose of not having to require a high power supply.

The first technique developed for on-site PD measurement tests was the very low frequency generator (0.1 Hz or 0.01 Hz). The low frequency of the generated voltage increases hundreds of times if it is 0.1 Hz, or thousands of times if it is 0.01 Hz, the capacitive reactance of the installation to be tested and, the power required during the test is thereby reduced in virtually the same proportion.

The drawback of this technique is that the generated alternating voltage wave duration is hundreds of times higher if it is 0.1 Hz or thousands of times higher if it is 0.01 Hz than the sinusoidal wave duration of 50 Hz or 60 Hz of the power grid where the high voltage equipment and installations operate. The voltage distribution inside insulations and the dielectric behaviour of insulations are known to be different for 0.1 Hz and 0.01 Hz voltages than for 50 Hz or 60 Hz voltages, so the tests do not reliably reflect the behaviour of the insulation when it is subjected to the grid voltage.

Damped alternating voltage generators generating high damped oscillating voltages having frequencies comprised between a tenth of a hertz and a kilohertz, which consist of charging the equipment or installation to be tested with a high direct voltage source and causing a damped oscillating voltage when discharging it on a coil, have emerged in recent years. The resistive value of the test circuit conductor causes the damping of the generated alternating voltage wave.

The limitation of this technique is that the maximum oscillating test voltage is applied only in the first crest of the voltage. The inevitable damping of the oscillating voltage wave provoked by the self-resistance of the actual circuit means that in the next wave half-periods have smaller amplitude and the wave is more considerably attenuated by a few tenths of a millisecond, causing less dielectric stress in the insulation. Dielectric stress, and therefore the result of the PD measurement in insulations, is known to depend not only on the instantaneous level of the test voltage, but also on the applied voltage duration. Therefore, UNE standard 60270 establishes the PD measurement in pC as the largest PD value occurring repeatedly throughout the test. For that purpose, the PD measurement instrument must be read as a function of the repetition rate of PD pulses per second, during which time the test voltage must remain constant without attenuation or damping.

Additionally, it is important to point out that the most common surge stresses in electric power transmission and distribution grids are due to single-phase short circuits causing surges in healthy phases during a time interval of the order of a few tenths of a second or even a second until the protections act. Accordingly, surges lasting a few hundredths of a second produced by the damped oscillating waves indicated in the preceding paragraph are not representative of the temporary surges of the grid.

The most advanced technical solution today for generating test voltages having the same frequency as the grid (50 Hz or 60 Hz) are fixed frequency LC resonant systems with variable inductance. The drawback of these systems is the required weight and volume.

Variable frequency LC resonant systems have also been developed having as advantages in relation to fixed frequency resonant systems a smaller generator weight (between half and five times less than the weight) and the higher compensated power ratio in relation to the active power required (between 1.2 to 2 times higher), but in contrast, the frequency is not exactly the grid frequency, but values comprised between 20 Hz and 300 Hz, which does not comply with the ideal target of testing insulations at the actual frequency of the grid where they operate (50 Hz or 60 Hz).

The proposal of the new invention seeks to solve this problem by compensating the reactive power by means of power electronics if the three phases are tested simultaneously by means of a FACT system. The weight and volume of the generator is also reduced by means of generating a high alternating voltage of 50 Hz during short time periods, of the order of a second, as if it were a temporary surge characteristic of a short circuit in the grid, then waiting a time interval to apply the test voltage again. A feasible example with current technology is to apply two seconds of test voltage for each real time minute, such that in 5 minutes a total of 500 wave periods of 50 Hz is provided, figure that is more than enough for the statistical treatment of the PD measurements which allows evaluating insulation condition. This method for testing, measuring and analysing allows requiring only maximum active power stresses in very isolated cases from the generator and thereby greatly reducing the weight and volume of the generator to values lower than those of the techniques used today.

The invention is set out in the appended set of claims.

## Brief Description of the Drawings

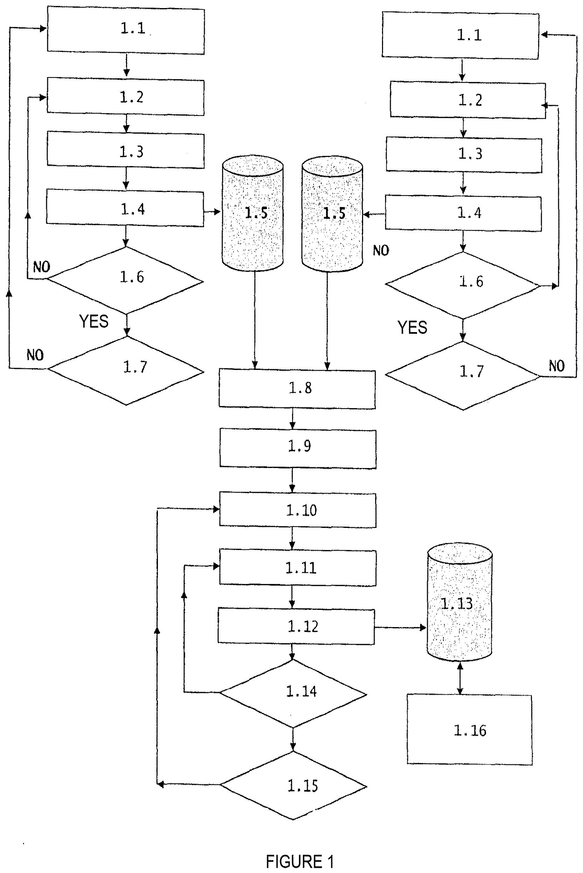

For the purpose of complementing the description and making the explanation thereof easier, Figure 1 is attached for a non-limiting illustrative purpose, depicting a flow chart illustrating the method of the present invention.

## Description of an Embodiment of the invention

As mentioned above, the present invention consists of a method for measuring and analysing the measurement, for a real time evaluation of the insulation condition of high voltage cables during their operation in the grid or when they are not connected to the network, which improves the techniques used today and corrects the drawbacks associated with these techniques as stated.

The objective of the present invention is to provide a new method for measuring and analysing the measurement of partial discharges for the real time evaluation of the insulation condition of high voltage machines, apparatuses, equipment and installations such as insulated cables, either during their normal operation in the grid or out of service in the grid, by means of using a test generator specifically designed for applying the indicated new method for measuring and analysing.

The present invention allows reducing the time necessary for analysing the measurement, for the purpose of performing a real time diagnosis, by the parallel use of several computing multiprocessors developed for personal computers. The new method also allows discriminating different focal points or sources producing partial discharges, both those occurring in locations that are physically close to one another, for example in one and the same high voltage apparatus, machine or element, such as in a cable junction or termination, or those occurring far from one another in different apparatuses, machines or other parts of a high voltage installation.

To apply the method for measuring, it is necessary to use a PD measurement system and a high voltage measurement system, both referring to the same time basis. The PD measurement system will be formed by an electromagnetic sensor working in a frequency range comprised between 50 kHz and 20 MHz and a high speed sampling digital recording channel controlled by a personal computer.

The method for evaluating the insulation condition of installations having a certain length (greater than 20 m) requires two measurement and measurement analysis systems synchronised in time, for example through a GPS signal. Each PD measurement system is located in a different position of the high voltage installation, spaced from one another by at least 20 m. PD sensors integrated in each accessory or external sensors outside the high voltage equipment can be used for that purpose.

Additionally, when the PD measurement is taken in high voltage installations there can be short range PD sensors, such as very high frequency (VHF) sensors, ultra-high frequency (UHF) sensors or acoustic sensors which only detect PDs produced close to the sensor (a few metres away from the sensor), so they must be placed in points where PDs are suspected to occur or in critical positions where the consequences of a failure would be disastrous. The comparison between the PD pulses acquired by these latter sensors located in a piece of equipment or accessory (for example a cable termination or junction) and the PD pulses detected by the electromagnetic sensors working between 20 kHZ and 20 MHz help to ratify the position of the PD sources.

This objective has been fully achieved with the present invention and is characterised by the attached claims in which the claimed method contemplates the stages that are described below and schematically shown in relation to the flow chart of Figure 1 of the drawing. Therefore:

The method for measuring partial discharges requires the sequence of stages indicated below. When the PD measurements are applied to high voltage installations, such as insulated cables, the first six stages are also repeated in the two synchronised measurement systems. It is also possible to take a PD measurement in smaller, individual equipment, such as electric machines (generators and transformers), switchgear, measurement transformers, using a single measurement system being sufficient, in which case the seventh and eighths (blocks 1.7 and 1.8) are not applied.

A first stage of the method (block 1.1) consists of performing captures starting in the instant of exact seconds of the UTC (Universal Time Coordinated). This capture start signal is achieved, for example, from the PPS (pulse per second) signal of a GPS receiver in a fixed position and by means of the sensing of at least four satellites, it achieves errors of absolute time of less than 10 nanoseconds. The capture process collects, on one hand, the signal coming from the PD sensor; the signal measurement is also collected by the test voltage sensor, plus the grid voltage signal (in the event that the excitation is not the grid voltage). The part of the signal collected by the PD sensor that will be used corresponds to an integer "n" of test voltage periods (n for 20 ms for 50 Hz voltages). Where a period starts and ends is established by means of analysing the test voltage signal. The number "n" of periods of each capture depends on the available memory for storing data and on the need to update results on the observation screen. During the PD capture time period, the applied voltage must be the test voltage for the PD measurement. When the grid voltage signal, in addition to the test voltage signal, has been collected it enables performing the following steps in relation to any of the two reference signals.

The second stage (block 1.2) consists of segmenting the total capture interval into "n" complete time periods of the reference signal (having a duration of 20 ms for the 50 Hz reference signal) which will primarily be the test voltage, but it can possibly be the grid voltage when it is different from the test voltage for the purpose of performing the numerical analysis of the PD signal measurement relating to the separation of the electric noise and the calculation of parameters of the PD-type signals in the next stages 3 and 4 (blocks 1.3 and 1.4 respectively) for each of the individual periods.

The third stage (block 1.3) consists of the real time separation of the electric noise from the signal acquired by the PD sensor by use of multiprocessors. The electric noise is a mixture of signals coupled to the PD signals, either in a conducted manner through the power supply system or the grounding system, or transmitted in a broadcast manner, for example by radio stations, mobile telephones, etc.

The removal of the electric noise is performed by means of numerical treatment of the captured signals consisting of applying the Wavelet transform to the acquired signal and statistically analysing its components for the purpose of finding transient events characteristic of PD signals which are distinguished from the statistical evolution of the electric noise.

The processing time of the signal applied for the numerical treatment for removing noise is drastically reduced, sharing out the numerical calculation tasks between the available "m" multiprocessors of the GPGPU used for that purpose. The greater the process time reduction achieved, the higher the number of multiprocessors available, the higher the clock frequencies of the processors, the clock frequency of the memory and the communication bandwidth with the main memory. The time reduction ratio achieved allows easily processing each 20 ms period of the signal coming from the PD sensor in a time of 100 ms, which allows updating the results screen instantaneously for visual purposes.

In the fourth stage (block 1.4) the individual PD signals are processed for the purpose of determining the following parameters for each PD-type signal: the absolute arrival time tiof the PD pulse in reference to the UTC time signal (for example GPS signal), the phase angle over time $\varphi i$ in relation to the zero-crossing of the test voltage signal. When the test voltage is different from the grid voltage, the phase angle over time $\varphi r i$is also determined in relation to the zero-crossing of the grid voltage signal. The representation in relation to the grid signal allows differentiating PD events distant from the test voltage.

The parameters identifying the shape of the PD-type signal are also calculated. The current waveform corresponding to each PD-type signal, damped oscillating transient wave ii(t), is modelled by means of a sinusoidal function gi (first part of formula (1)), modulated by an function envelope ei (second part of formula (1)), which is defined in this invention as the asymmetrical hyperbolic secant because it corresponds with the mathematical hyperbolic secant function in which the parameters of the two exponential functions of the denominator are no longer equal in order to lose the symmetry in relation to the y-axis (second part of the equation (1)).

$$i_i(t) = g_i(t) \cdot e_i(t) = \left(sine(\omega_i \cdot t - \psi_i)\right)\left(\frac{A_i}{e^{\alpha_i \cdot (t - t_{0i})} + e^{\beta_i \cdot (t - t_{0i})}}\right) \quad (1)$$

Where:

t is the time variable,
gi(t) is the sinusoidal function associated with the i-th pulse having a frequency fi =[$\omega i /2\pi$] displaced $\psi i$ radians for the instant t=0,
$\omega i$ pulse of the sinusoidal wave associated with the i-th pulse,
$\psi i$ is the angular displacement of the sinusoidal wave associated with the i-th pulse for the time instant t=0,
ei is a function similar to the expression of the hyperbolic secant associated with the i-th pulse which, when the parameters $\alpha i$ and $\beta i$ are different, asymmetry is achieved. This function modulates the amplitude Ai of the sinusoidal function gi.
t0i is the temporal displacement of the asymmetrical hyperbolic secant modulating the i-th oscillation pulse,
Ai is the parameter directly correlated with the maximum amplitude of the envelope in combination with $\alpha i$ and $\beta i$,
$\alpha i$ and $\beta i$ are the envelope shape parameters correlated to the front time and the tail time of the envelope wave.

Formula (1) has been obtained after an in-depth investigation of different mathematical models which best fit with the transient evolution of the damped oscillating pulse characteristic of a PD, with the parameters necessary for representing any type of PD signal and with a sensitivity of their parameters suitable for numerical calculation.

The best option of the six shape parameters t0i, $\psi i$, fi, Ai, $\alpha i$ and $\beta i$ for the "i-th" PD-type pulse is determined by means of a genetic search algorithm.

The use of multiple processors allows assigning to each processor the parameter search operations such that they better define each PD pulse. The parallel work of the "m" multiprocessors allows determining a broad set of genetic variations (around 4000) of each PD pulse for the purpose of choosing the best option for each of the PD pulses.

In the fifth stage (block 1.5), the best shape parameters determined for each PD-type pulse, are stored in the database of the computer controlling the measuring system.

Even though there are six shape parameters determined by means of the indicated numerical processing, the parameters that are independent of the instant which a PD is produced are the following three: pulse oscillation frequency, fi, rising rate and falling rate of the PD pulse envelope (associated with the parameters $\alpha i$ and $\beta i$). The parameters t0i and $\psi i$ are parameters that can be attributed to displacements over time of the functions gi(t) and ei(t), and the parameter Ai corresponds to a scaling factor.

In the sixth stage (block 1.6), the process of the third, fourth and fifth stages (blocks 1.3 a 1.5) is repeated until completing the acquired "n" periods.

In the seventh stage (block 1.7), the first stage (block 1.1) is repeated to enable again applying the stages comprised between the second and the sixth stages (blocks 1.2 to 1.6), until completing a statistically representative number of acquisitions so that the PDs can be immediately and reliably clustered by position, the PDs can be clustered in each position according to the shape of the pulse and the results of each PD source (magnitude, rate and phase resolved pattern of the voltage) can be determined, corresponding to the ninth, tenth and eleventh stages (blocks 1.9, 1.10 and 1.11 respectively). The number of acquisitions that is considered statistically minimum for reliably performing the mentioned analysis is 250, but the higher this number the more reliable the diagnosis will be.

The eighth stage (block 1.8) consists of representing the values of magnitude of the phase resolved discharge of the test voltage ($\varphi i$). When the grid voltage is different from the test voltage, the same values of the magnitude of the phase resolved discharge of the grid voltage ($\varphi ri$) are also represented. When the PDs are correlated to the phase of the grid voltage ($\varphi ri$), the representation of the magnitude of the phase resolved discharge of the test voltage ($\varphi i$) will be distributed without any reference pattern; whereas the magnitude of the phase resolved discharges of the grid voltage will correspond to a reference pattern. This allows excluding PDs originating from the grid voltage and which are therefore not generated in the element under testing.

The ninth stage (block 1.9) consists of communicating both computers so that both databases containing PD pulse parameters obtained by both independent measurement systems can be correlated using the acquisitions synchronised in time by means of UTC, for example GPS.

In the tenth stage (block 1.10), the PD sources detected in different discrete positions throughout the installation are clustered together. Taking into account the data stored in the databases of the two measurement systems corresponding to the fifth stage (blocks 1.5), the position map of the PD sources is determined as a function of the position that the PD-type signals occupy along the length of the cable. The mentioned map is constructed as a function of the delay in arrival to each sensor of the PD pulses paired by proximity, $xi(\Delta ti)$, taking into account the maximum time delay possible between two PD pulses, the ratio between the maximum length to be travelled and the propagation speed.

"Position of PD pulses" must be understood as positions having a minimum length of about 3 m. The position is identified in relation to the relative distance to a specific sensor used as a reference.

The eleventh stage (block 1.11) consists of separating the PDs located in one and the same position, those having PD pulses with different shape parameters. It is known that the shape of the PD pulse (rise time, fall time, oscillation frequency) can change as a function of the physical phenomenon associated with a PD, of the distance travelled by the PD and of the test and measurement circuit. Accordingly, if there are different types of defects in a single position that produce PD-type signals, it will be possible to identify the different PD sources through the shape parameters associated with the PD pulses of each source generating PDs.

A three-dimensional representation of the most representative shape parameters of the pulses, fi, $\alpha i$ and $\beta i$, is made to enable applying this step, and a clustering tool is applied for determining the different focal points associated with different sets of discharges in said three-dimensional space.

The twelfth stage (block 1.12) consists of determining the measurement and analysis results for each PD source: magnitude of the PD, rate of repetition of the PD and pattern of the phase resolved PDs for the voltage. The magnitude of the PD pulses and the rate of repetition of PD signals are determined for each PD source as mean values of each acquisition second. These two pieces of data are determined by statistical analysis of the set of PDs located in the each position where PDs occur:

The magnitude of the partial discharge is determined as the largest magnitude repeatedly occurring in each of the sensors, which is calculated through the quasi-peak value of the amplitudes of the PD signals recorded per each second of signal captured. The amplitude of each PD pulse sensed by each sensor is corrected as a function of the length travelled.

The rate of repetition is determined as the mean value of the PD-type signals of a certain level detected in a time period at least throughout an acquisition second.

The risk of insulation failure is known to depend on the physical process causing the PD pulses, e.g., corona in air pulses are not crucial for causing the dielectric breakdown of the insulation, but partial discharges due to an internal cavity-type defect are critical for the insulation service life. It is therefore very important to know the type of defect associated with each PD source to enable evaluating the insulation condition of a cable and of its accessories (terminals and junctions). The representation of the magnitude of the discharge in relation to the phase with reference to the test voltage ($\varphi i$) of the pulses of each PD source generates visual patterns which experience has proven to be highly correlated to the different types of phenomena causing the occurrence PD events. The recognition of the formed pattern allows evaluating the risk of failure of each of the PD sources. A neural network for pattern recognition is applied to each of the PD sources detected for automatic recognition, the training of which network has been conducted based on the patterns offered by laboratory samples and field tests through which the type of defect is known with certainty.

In the thirteenth stage the measurement and analysis results for each PD source (magnitude, rate of repetition and phase resolved pattern of the voltage) are stored in a database (block 1.13).

In the fourteenth stage (block 1.14), the eleventh to the thirteenth stages (blocks 1.11 to 1.13) are repeated for each PD source located in a specific position, and in stage fifteenth (block 1.15) the preceding process is again repeated for each set of PDs located in the different positions of the cable.

A user interface (block 1.16), schematically shown in Figure 1, allows showing the processed data for performing the final evaluation of the insulation condition of the cable from the following information:

- Position map of the PDs where the PD sources are located (block 1.10).
- Clusters of different PD sources in each position (block 1.11).
- Results obtained from each PD source as a function of time: magnitude, rate of repetition, phase resolved pattern of the voltage for each PD source (block 1.12).
- Type of defect associated with each source obtained from the neural network (block 1.12).

The new method for monitoring partial discharges in cables that are installed and in service for discriminating, locating, measuring, identifying and diagnosing partial discharge sources has been sufficiently described above. Additionally, another object of the invention is the implementation of a system for carrying out said method, which will be described below.

The physical system for applying the proposed method is made up of one or two sub-systems for measuring and analysing the measurement of partial discharges and a sub-system for generating high alternating 50 Hz voltage particularly designed and suited to the mentioned method for measuring when the PD measurements must be performed without the grid voltage (out of service). In the event that the measurements are taken under service conditions or when they are taken under out of service conditions, the diagnosis of the insulation condition is done in the same manner in brief time periods.

PD measurement sub-systems for applying the method.

For the complete application of the method for measuring and analysing described in the flow chart of Figure 1 it is necessary to use two measurement systems, MS, for measuring each of the PD signals located at opposing ends of the installation to be tested. The MS include a PD measurement sensor, a measurement sensor for measuring the waveform of the test high voltage, a measurement sensor for measuring the waveform of the high voltage of the grid, a digital recorder, a UTC receiver, for example GPS, a personal computer with multiple processing capacity and a portable computer for remote control for the purpose of isolating the operator.

The PD-type signals together with the electric background noise present are captured and recorded by the measurement system (MS) in a synchronised manner through the UTC time reference (block 1.1 of the flow chart of Figure 1 ). Each MS performs the processing of the collected signals:

- It segments the capture time into periods to perform the analysis (block 1.2),
- discriminates the electric background noise from the PD-type signals (block 1.3),
- determines the parameters representative of each PD pulse (block 1.4) and stores them (block 1.5),
- repeats the process until completing the capture period (blocks 1.6 and 1.7),
- the PDs originated by the grid voltage far from the element under testing are excluded (block 1.8).

After the capture and the first processing of signals performed separately by each measurement system (blocks 1.1 to 1.8), both measurement systems are interconnected, with or without a cable, to transfer the data to one of them from the other. Any of the two computers has the necessary calculation tools for completing the processing of the analysis of the measurement and obtaining the final results of the evaluation of the insulation condition (blocks 1.10 to 1.17) for the purpose of displaying said results on the screen of the computer used (block 1.17 of the flow chart of Figure 1).

Each measurement system, MS, arranged in the installation under testing is made up of:

- one Partial Discharge Sensor per phase to be analyzed, PDS. The non-invasive sensors used are high frequency current transformers (HFCT) having a bandwidth comprised between 1 MHz and 20 MHz which are arranged coupled to the conductors of the connections to ground. The invasive sensors are integrated in equipment or elements of the installation,
- one Test Voltage Sensor, TVS, for measuring the waveform of the test voltage. In the event of measurements in service, an output of a measurement and protection transformer of the actual grid, or a sensor capacitively coupled to the phase where the measurement is taken, can be used. A 50 Hz current transformer arranged in a ground connection of the high voltage cables can also alternatively be used. In this latter case, the electric phase difference of the measured capacitive current signal must be delayed 90° in relation to the voltage wave object of measurement. If the measurement is taken when out of service, the signal will be obtained from the low voltage branch of a voltage divider by means of a high alternating voltage generator,

- a Grid Voltage Sensor, GVS, for measuring the grid voltage waveform in the event that it is different from the test voltage. An output of a measurement and protection transformer of the actual network, or a 50 Hz current transformer arranged in the conductor of the ground connection of the high voltage cables not forming part of the test and connected to the grid voltage can be used. In this latter case, the electric phase difference of the mainly capacitive current signal must be delayed 90° in relation to the voltage wave object of measurement,

- a card for receiving the UTC time signal, for example a GPS card which is synchronised with the UTC time by means of the PPS (Pulse Per Second) signal, allowing the synchronised Trigger Pulse Generation (TPG),

- a Digital Recording, DR, Card triggered by the synchronisation pulse coming from the TPG. The PDS is connected to a channel of the DR, the sampling speed and vertical resolution of which is at least 100 Mega-samples per second and 10 bits, respectively. The channel intended for the voltage waveform could have much less demanding features (32 kilo-samples per second).

- Protection and Control Equipment, PCE, protecting the two DRs of the MS against surges,

- a personal computer with multiple processing capacity through one or several multiprocessing units.

- a portable computer for controlling the measurement system remotely.

<u>Sub-system for generating a high alternating voltage of 50 Hz applied to the new method for the measurement and analysis of PDs.</u>

The system for generating a high alternating voltage of 50 Hz of the present invention subjects the equipment or installation to be tested to the test voltage only for short time periods in which the PD signals are captured (block 1.1 of the flow chart of Figure 1 ). After each time interval for generating the high test voltage, the output voltage of the generator is reduced to a low enough value so that the power dissipated by the generator is negligible (waiting state), and the heat generated in the prior operation condition can be dissipated. The ratio, r, between the waiting time interval in relation to the time period for generating the high test voltage is established with a specific ratio compatible with the technology of the high voltage transformer used, for example, a maximum ratio of 5:1 could reasonably correspond to 10 seconds of high voltage generated with 50 seconds of waiting state per each time minute, so that the equivalent thermal load in the operation steady state is much lower than that required when operating at the test voltage.

In each test period tt in which the high test voltage is generated, the test current, It required by the equipment or installation to be tested, is supplied by the generator causing a thermal load. The current le during the waiting period te is reduced to a percentage p in relation to the current during the test. The comparison between the thermal load in this pulsed state in relation to the thermal load in continuous operating steady state of a permanent nominal current generator Ip meets the following equation:

$$I_t^2.t_t + I_e^2.t_e = I_p^2.t_p \qquad (2)$$

Where it results that

$$I_p = I_t.\sqrt{\frac{1+r.p}{1+r}}$$

By way of example, if the ratio r=te/tt= 5 and the percentage of current in waiting condition is 25% in relation to the test current (p=0.25), it results that with one generator of the steady state nominal power having half the value of that required at the test voltage would be sufficient under the thermal load viewpoint.

By way of example, a test installation having a steady state nominal power of 250 kVA can be used in the indicated pulsed state (r=5 and p=0.25) to supply test powers of up to 500 kVA, without being heated above the nominal value.

During the period of generating high voltage, for example 10 seconds in a minute, at least, one time interval (for example 2 seconds), the high PD measurement voltage will be reached so that immediately during the waiting operation period of the generator, for example 50 seconds, the measurement system has enough time to perform the numerical processing of the signals, corresponding to filtering and determining the parameters representative of each PD-type pulse (blocks 1.2 to 1.6 of the flow chart of Figure 1). The high test voltage will then be generated again to perform a new capture, and the process will be repeated as many times necessary (blocks 1.6 and 1.1 of the flow chart of Figure 1 ). The number of times that the capture and analysis process is repeated must be enough so as to provide statistically reliable data. It is known that with a number of captures corresponding to 250 periods of the test voltage wave (for example 20 ms for 50 Hz) sufficient data is available for reliably performing the analysis corresponding to the tenth, eleventh and twelfth stages of the flow chart of Figure 1. The higher the number of periods captured the more reliable the diagnosis will be.

By way of example, if in the time interval for generating a high voltage the time period reached by the test voltage intended for the PD capture and measurement is of the order of 2 seconds per each time minute and the process is repeated five consecutive times (5 minutes of testing), then twice the amount of test sinusoidal wave periods established as necessary (500 periods of data) will be available for performing the diagnosis of the insulation condition of the equipment or of the installation. Accordingly, in 5 minutes of testing it is possible to perform a reliable diagnosis with a voltage having the same frequency as the grid.

Additionally, considering that the duration of the test does not require exceeding a tenth of minutes and that no other test will be performed until after an hour has elapsed, the nominal power of the generator in steady state in relation to the maximum power delivered can be further reduced. The use of step-up transformers having lower power provides the fundamental advantage of a considerable weight reduction.

For the purpose of not having to supply more than the active power of losses, the reactive power required during the test is compensated by means of FACT-type power electronics, the weight of which is also reduced. Vector control of the FACT is performed with a reduced number of switching pulses to limit the interfering signal content during partial discharge measurement due to the switching of the electronic power switches at the same time of complying with the condition that the difference between the effective value of the generated voltage and the crest value divided by the square root of 2 does not exceed 15%. The combined use of a three-phase step-up power transformer and three-phase FACT for testing balanced tri-phase loads allows substantially reducing the use of traditional reactive compensation elements (reactors and condensers), the weight and volume of which have traditionally been a serious drawback. Additionally, the simultaneous test of the three phases provides the substantial advantage of reducing the test time.

The circuit of the test generation system is made up of the following elements:

- a low voltage automatic switch for the connection, disconnection and protection,
- a autotransformer that is adjustable by means of monitoring low voltage, provided for providing the active power required in the test,
- a servomotor to adjust the output voltage of the autotransformer controlled by a computer for the purpose of coordinating the time periods in which the high test voltages are generated with the waiting periods, used for capturing, recording and analysing the signals coming from the PD sensors,
- a three-phase FACT for compensating the reactive power required in the test,
- a three-phase power transformer to increase the voltage from a low voltage to the test voltage.

## Claims

1. A method for performing real time tests and diagnosis of sources of partial discharges, or PDs, produced in high voltage equipment or installation, which are either operating, or not operating, by discriminating background noise, identifying the position of the PDs, distinguishing between different sources of PDs located in a single position, determining, for each source of PD, its magnitude, rate of repetition and type of associated fault, **characterized in that** the method comprises the following steps:

   - in step 1, performing synchronised capture and digitization of analogue signals respectively collected by two PD sensors belonging to two measurement systems and each located at the respective ends of the installation, to be diagnosed together with analogue signals collected by two voltage sensors, a first one for sensing a sine wave test voltage and another one for sensing a grid voltage, all the said signal captures starting in the instant that the UTC, or Universal Time Coordinated time signal, coincides with an exact second, being supported for such purpose on, for example, a PPS, or pulse per second, signal delivered by a GPS receiver, and each signal capture having a global period covering one or more complete periods of the test voltage wave;
   - in step 2, segmenting the captured and digitized signals in time intervals equal to the periods of the sine wave test voltage signal;
   - in step 3, discriminating in real time, through the use of multiprocessors, within the signal measured by each PD sensor captured in step 1, between background electric noise and the transient waveform characteristic of the partial discharge-type, or PD-type, signal by applying Wavelet transform together with a statistical treatment

EP 2 579 056 B1

of the measured signal;

- in step 4, determining for each PD-type signal, the time instant, ti, in which it occurs on the absolute UTC time reference, associated with the phase difference of the PD-type signal in relation to the zero-crossing of the test voltage wave, φi, and in relation to the zero-crossing of the grid voltage wave, φri , in the event that the grid voltage is different from the test voltage; as well as determining in real time, through the use of said multiprocessors, for each i-th PD-type signal, characterized as a damped oscillating event, the parameters of the mathematical function referred to as asymmetrical hyperbolic secant

$$e_i(t) = \frac{A_i}{e^{\alpha_i \cdot (t - t_{0i})} + e^{-\beta_i \cdot (t - t_{0i})}}$$

where :

- t is the time variable;
- toi is the temporal displacement of the asymmetrical hyperbolic secant function associated with the i-th pulse;
- ei(t) is the hyperbolic secant function associated with the i-th pulse which is asymmetrical, when the parameters αi and βi are different;
- Ai is the parameter directly correlated with the maximum amplitude of the envelope wave; and
- αi and βi are the shape parameters correlated to the rise time and the fall time of the envelope wave,

which best fits with the envelope of the damped oscillating event characterizing the PD-type signal and extracting from this fitted function the two parameters αi and βi representative of the shape of the envelope, respectively in relation to the rise time and fall time of the signal, which are associated with the two coefficients αi and βi of the denominator of the asymmetrical hyperbolic secant function; together with determinating in real time, through the use of said multiprocessors, for each PD-type signal, the parameters of the sinusoidal function

$$g_i(t) = sine(\omega_i \cdot t - \psi_i)$$

where :

- gi(t) is the sinusoidal function associated with the i-th pulse having a frequency fi (= ωi/2π) displaced φi radians for the instant t=0;
- ω1 is the pulsation of the sinusoidal wave associated with the i-th pulse;
- Ψi is the angular displacement of the sinusoidal wave associated with the i-th pulse for t=0;

which best fits with the oscillation of said damped oscillating event characterizing the PD-type signal; extracting from this fitted function the parameters of the fundamental frequency fi =ωi /2π as an additional shape-representative parameter;

- in step 5, storing the calculated parameters characteristic of each partial discharge pulse determined in step 4;
- in step 6, repeating the steps 2 to 5 for each period interval of the test voltage of the global period of the PD signal captured in step 1;
- in step 7, performing new captures for the purpose of repeating the preceding steps 2 to 6 enough times to enable having statistically sufficient data for reliably determining the position of the PD sources, the number of different PD sources located in each position and the parameters representative of each PD source, which correspond to the magnitude of the discharge, the rate of repetition of PD pulses and the phase-resolved patterns of the test voltage and of the grid voltage; the number of acquisitions considered sufficient for the mentioned calculation being 250 periods of the grid voltage wave;
- in step 8, excluding PDs originating in the grid voltage far from the equipment under testing, when the grid voltage is different from the test voltage, by means of representing the magnitude of the phase-resolved PD of the grid voltage φ(i) determined in step 4;
- in step 9, correlating said parameters characteristic of each PD signal measured with the two measurement systems to enable determining the position of the PD sources by using the absolute time reference obtained in step 4;
- in step 10, determining the position map of PD sources taking into account the delay in arrival of the PD pulses to each sensor measured with a different measurement system and paired by proximity, xi ($\Delta$ti), taking into account the maximum possible time delay between the PD pulses received by the two measurement systems, the ratio between the maximum length to be travelled by the PD pulse and the propagation speed of the PD pulse;
- in step 11, identifying the number of different PD sources for each position of PD sources through the formation of groups of PD signals having similar values of the three following parameters obtained in step 4: the two parameters representative of the shape of the envelope of the PD-type signal, related to the rise time and the fall time, namely αi and βi, and the parameter of the fundamental frequency fi of the damped oscillation pulse characteristic of the PD signal;
- in step 12, determining for each PD source a value representative of the magnitude of the discharge, of the rate of repetition of PD pulses associated with each acquisition second, as well as the phase-resolved pattern of the PD pulses of the test voltage wave, correlating it in relation to typical fault reference patterns, for example by means of a neural network structure trained in known typical fault patterns;
- in step 13, storing the parameters determined in steps 10 to 12;
- in step 14, repeating the process for determining parameters calculated in step 12 for each PD source;
- in step 15, repeating the process indicated in steps 11 to 14 for the PD sources associated with each PD position;
- in step 16, graphically representing the results of the steps 10 to 12, corresponding to the position map of PDs where the PD sources are located, as determined in step 10, to the groups of different sources of PDs located in each position, as identified in step 11, and to the results obtained for each PD source, as determined in step 12, corresponding to the magnitude of the discharge, the rate of repetition, the phase resolved patterns of PDs of the test voltage and the result of the type of fault associated with each PD source of the network.

2. A physical system for detecting partial discharge-type, or PD-type signals for carrying out the method according to claim 1, which allows taking simultaneous and synchronised measurements in the two measurement systems for measuring PDs, discriminating the noise in relation to the transient waveform characteristic of the PD signals, determining the parameters associated with each PD, determining the map of PD along the length of a cable according to step 10, graphically representing the groups of the sources of PDs, graphically representing the results of the analysis, said physical system being made up of the two independent measurement systems, each having the following elements:

- a partial discharge sensor;
- a voltage sensor for measuring the test voltage waveform;
- a voltage sensor for measuring the grid voltage waveform in the event that it is different from the test voltage;
- a card for receiving the UTC time signal, for example from a GPS system, and another card for synchronised trigger pulse generation, or TPG;
- a digital recorder triggered by the synchronisation pulse coming from the synchronised trigger pulse card;
- a protection and control equipment, protecting each digital recorder of the measurement system against surges;
- a personal computer with multiple processing capacity through one or several multiprocessing units;
- a portable computer for remotely controlling the measurement system.

3. A physical system according to claim 2, for further generating alternating high voltages of the frequency of the supply voltage, for example 50 Hz or 60 Hz, wherein the system is configured to generate the test alternating high voltage during short time periods, in which the PD signals are captured according to step 1 of claim 1; the system further configured to reduce the voltage for a waiting time period, longer than the period during which the test alternating high voltage is generated, to a value low enough for allowing dissipation of the heat produced in the instants of generating the alternating high voltage for testing using each reduced voltage period for analyzing the measurements relating to the steps 2 to 7 of claim 1 and thus being able to supply a pulsed state power that is much greater than the steady-state nominal power of the generator, while at the same time the reactive power required in the test is compensated by means of FACT-type power electronics for the purpose of limiting the use of reactors and condensers for compensating the reactive power required in the test.

**Patentansprüche**

1. Verfahren zum Durchführen von Echtzeittests und zur Diagnose von Quellen von Teilentladungen oder PDs, die in einer Hochspannungsausrüstung oder - anlage aufgetreten sind, die entweder in Betrieb sind oder nicht in Betrieb sind, durch Unterscheiden von Hintergrundrauschen, Identifizieren der Position der PDs, Unterscheiden zwischen verschiedenen Quellen von PDs, die sich an einer einzigen Position befinden, Bestimmen, für jede PD-Quelle, ihrer Größe, Wiederholungsrate und Art des assoziierten Fehlers, **dadurch gekennzeichnet, dass** das Verfahren die folgenden Schritte umfasst:

- in Schritt 1, Durchführen von synchronisierter Erfassung und Digitalisierung von analogen Signalen, die jeweils von zwei PD-Sensoren gesammelt werden, die zu zwei Messsystemen gehören und sich jeweils an den jeweiligen Enden der Anlage befinden, um zusammen mit analogen Signalen diagnostiziert zu werden, die von zwei Spannungssensoren gesammelt werden, einem ersten zum Abtasten einer Sinuswellenprüfspannung und einem anderen zum Abtasten einer Netzspannung erfasst, wobei alle Signalerfassungen in dem Moment beginnen, in dem das Zeitsignal UTC oder Universal Time Coordinated mit einer exakten Sekunde übereinstimmt, und sich zu diesem Zweck beispielsweise auf ein von einem GPS-Empfänger geliefertes PPS-Signal (Puls pro Sekunde) stützen, und jede Signalerfassung eine globale Periode aufweist, die eine oder mehrere vollständige Perioden der Prüfspannungswelle abdeckt;
- in Schritt 2, Segmentieren der erfassten und digitalisierten Signale in Zeitintervalle, die den Perioden des Sinuswellenprüfspannungssignals entsprechen;
- in Schritt 3, Unterscheiden in Echtzeit, durch die Verwendung von Multiprozessoren, innerhalb des Signals, das von jedem in Schritt 1 erfassten PD-Sensor gemessen wird, zwischen elektrischem Hintergrundrauschen und der für das Signal vom Typ Teilentladung oder PD charakteristischen transienten Wellenform durch Anwenden der Wavelet-Transformation zusammen mit einer statistischen Behandlung des gemessenen Signals;
- in Schritt 4, Bestimmen für jedes Signal vom Typ PD den Zeitpunkt ti, an dem es in der absoluten UTC-Zeitreferenz auftritt, assoziiert mit der Phasendifferenz des Signals vom Typ PD in Bezug auf den Nulldurchgang der Prüfspannungswelle φi und in Bezug auf den Nulldurchgang der Netzspannungswelle φri für den Fall, dass sich die Netzspannung von der Prüfspannung unterscheidet; sowie Bestimmen der Parameter der als asymmetrische hyperbolische Sekante bezeichneten mathematischen Funktion für jedes i-te Signal vom Typ PD, das als gedämpftes Schwingungsereignis gekennzeichnet ist, in Echtzeit durch die Verwendung der Multiprozessoren

$$e_i(t) = \frac{A_i}{e^{\alpha_i \cdot (t - t_{0i})} + e^{-\beta_i \cdot (t - t_{0i})}}$$

wobei:

- t die Zeitvariable ist;
- toi die zeitliche Verschiebung der asymmetrischen hyperbolischen Sekantenfunktion ist, die mit dem i-ten Impuls assoziiert ist;
- ei(t) die hyperbolische Sekantenfunktion ist, die mit dem i-ten Impuls assoziiert ist, der asymmetrisch ist, wenn die Parameter $\alpha i$ und $\beta i$ verschieden sind;
- Ai der Parameter ist, der direkt mit der maximalen Amplitude der Hüllwelle korreliert; und
- $\alpha i$ und $\beta i$ die Formparameter sind, die mit der Anstiegszeit und der Abfallzeit der Hüllkurve korrelieren,

die sich am besten an die Hüllkurve des gedämpften Schwingungsereignisses anpasst, das das Signal vom Typ PD charakterisiert, und Extrahieren der zwei Parameter $\alpha i$ und $\beta i$ aus dieser angepassten Funktion, die repräsentativ für die Form der Hüllkurve sind, jeweils bezogen auf die Anstiegszeit und die Abfallzeit des Signals, die den zwei Koeffizienten $\alpha i$ und $\beta i$ des Nenners der asymmetrischen hyperbolischen Sekantenfunktion assoziiert sind; mit Bestimmung der Parameter der Sinusfunktion in Echtzeit für jedes Signal vom Typ PD durch die Verwendung der Multiprozessoren

$$g_i(t) = sine(\omega_i \cdot t - \psi_i)$$

wobei:

- gi(t) die mit dem i-ten Impuls assoziierte Sinusfunktion ist, die eine Frequenz fi (= $\omega i / 2\pi$) aufweist, die um φi Radianten für den Zeitpunkt t=0 verschoben ist;

- ωi die Pulsation der Sinuswelle ist, die mit dem i-ten Impuls assoziiert ist;
- Ψi die Winkelverschiebung der Sinuswelle ist, die mit dem i-ten Impuls für t=0 assoziiert ist;

die am besten mit der Schwingung des gedämpften Schwingungsereignisses übereinstimmt, das das Signal vom Typ PD charakterisiert; Extrahieren der Parameter der Grundfrequenz fi =ωi /2π aus dieser angepassten Funktion als zusätzlicher formrepräsentativer Parameter;

- in Schritt 5, Speichern der berechneten Parameter, die für jeden in Schritt 4 bestimmten Teilentladungsimpuls charakteristisch sind;
- in Schritt 6, Wiederholen der Schritte 2 bis 5 für jedes Periodenintervall der Prüfspannung der Gesamtperiode des in Schritt 1 erfassten PD-Signals;
- in Schritt 7, Durchführen neuer Erfassungen, um die vorherigen Schritte 2 bis 6 ausreichend oft zu wiederholen, dass statistisch ausreichende Daten zur zuverlässigen Bestimmung der Position der PD-Quellen, der Anzahl der verschiedenen PD-Quellen, die sich an jeder Position befinden, und der für jede PD-Quelle repräsentativen Parameter, die der Größe der Entladung, der Wiederholungsrate der PD-Impulse und den phasenaufgelösten Mustern der Prüfspannung und der Netzspannung entsprechen, vorliegen; wobei die Anzahl an Erfassungen, die für die genannte Berechnung als ausreichend angesehen wird, 250 Perioden der Netzspannungswelle ist;
- in Schritt 8, Ausschließen von PDs, die von der Netzspannung fern von der zu prüfenden Ausrüstung ausgehen, wenn sich die Netzspannung von der Prüfspannung unterscheidet, durch Darstellen der Größe der phasenaufgelösten PD der Netzspannung φ(i), die in Schritt 4 bestimmt wird;
- in Schritt 9, Korrelieren der Parameter, die charakteristisch für jedes PD-Signal sind, das mit den zwei Messsystemen gemessen wird, um die Position der PD-Quellen unter Verwendung der in Schritt 4 erlangten absoluten Zeitreferenz zu bestimmen;
- in Schritt 10, Bestimmen der Positionskarte von PD-Quellen unter Berücksichtigung der Verzögerung beim Eintreffen der PD-Impulse an jedem Sensor, die mit einem anderen Messsystem gemessen und durch Nähe xi (Δti) gepaart werden, wobei die maximal mögliche Zeitverzögerung zwischen den von den zwei Messsystemen empfangenen PD-Impulsen, das Verhältnis zwischen der maximal von dem PD-Impuls zu durchlaufenden Länge und die Ausbreitungsgeschwindigkeit des PD-Impulses berücksichtigt werden;
- in Schritt 11, Identifizieren der Anzahl von verschiedenen PD-Quellen für jede Position von PD-Quellen durch die Bildung von Gruppen von PD-Signalen mit ähnlichen Werten der drei folgenden, in Schritt 4 erlangten Parameter: die zwei Parameter, die repräsentativ für die Form der Hüllkurve des PD-Signals sind und sich auf die Anstiegszeit und die Abfallzeit beziehen, nämlich αi und βi, und der Parameter der Grundfrequenz fi der gedämpften Schwingungsimpulscharakteristik des PD-Signals;
- in Schritt 12, Bestimmen eines Werts für jede PD-Quelle, der repräsentativ ist für die Größe der Entladung, die Wiederholungsrate der PD-Impulse, die mit jeder Erfassungssekunde assoziiert sind, sowie das phasenaufgelöste Muster der PD-Impulse der Prüfspannungswelle, und Korrelieren dieser Werte mit typischen Fehlerreferenzmustern, z. B. mittels einer neuronalen Netzstruktur, die an bekannten typischen Fehlermustern trainiert wurde;
- in Schritt 13, Speichern der in Schritt 10 bis 12 bestimmten Parameter;
- in Schritt 14, Wiederholen des Verfahrens zum Bestimmen der in Schritt 12 berechneten Parameter für jede PD-Quelle;
- in Schritt 15, Wiederholen des Verfahrens, das in Schritt 11 bis 14 beschrieben ist, für die PD-Quellen, die mit jeder PD-Position assoziiert sind;
- in Schritt 16, grafisches Darstellen der Resultate der Schritte 10 bis 12, entsprechend der in Schritt 10 bestimmten Positionskarte von PDs, wo sich die PD-Quellen befinden, den in Schritt 11 identifizierten Gruppen verschiedener PD-Quellen, die sich an jeder Position befinden, und den in Schritt 12 bestimmten Resultaten, die für jede PD-Quelle erlangt werden, entsprechend der Größe der Entladung, der Wiederholungsrate, den phasenaufgelösten Mustern der PDs der Prüfspannung und dem Resultat des Fehlertyps, der mit jeder PD-Quelle des Netzes assoziiert ist.

2. Physikalisches System zum Erfassen von Teilentladungssignalen oder PD-Signalen zum Durchführen des Verfahrens nach Anspruch 1, das ein Vornehmen gleichzeitiger und synchronisierter Messungen in den zwei Messsystemen zur Messung von PDs, eines Unterscheidens des Rauschens in Bezug auf die transiente Wellenformcharakteristik der PD-Signale, ein Bestimmen der Parameter, die mit jeder PD assoziiert sind, ein Bestimmen der Karte von PDs entlang der Länge eines Kabels gemäß Schritt 10, ein grafisches Darstellen der Gruppen der Quellen von PDs und ein grafisches Darstellen der Resultate der Analyse ermöglicht, wobei das physikalische System aus den zwei unabhängigen Messsystemen besteht, die jeweils die folgenden Elemente aufweisen:

- einen Teilentladungssensor;
- einen Spannungssensor zum Messen der Prüfspannungswellenform;
- einen Spannungssensor zum Messen der Netzspannungswellenform für den Fall, dass diese von der Prüfspannung abweicht;
- eine Karte zum Empfangen des UTC-Zeitsignals, z. B. von einem GPS-System, und eine weitere Karte zur Erzeugung synchronisierter Triggerimpulse, oder TPG;
- ein digitales Aufzeichnungsgerät, das durch den von der synchronisierten Triggerimpulskarte kommenden Synchronisationsimpuls ausgelöst wird;
- eine Schutz- und Steuereinrichtung, die jedes digitale Aufzeichnungsgerät des Messsystems vor Überspannungen schützt;
- einen Personal Computer mit mehrfacher Verarbeitungskapazität durch eine oder mehrere Multiprozessoreinheiten;
- einen tragbaren Computer zum Fernsteuern des Messsystems.

**3.** Physikalisches System nach Anspruch 2 zum weiteren Erzeugen von Wechselhochspannungen mit der Frequenz der Versorgungsspannung, beispielsweise 50 Hz oder 60 Hz, wobei das System so konfiguriert ist, dass es Prüfwechselhochspannung während kurzer Zeiträume erzeugt, in denen die PD-Signale gemäß Schritt 1 von Anspruch 1 erfasst werden; das System ferner konfiguriert ist, um die Spannung für eine Wartezeitperiode, die länger ist als die Periode, während der die Prüfwechselhochspannung erzeugt wird, auf einen Wert zu reduzieren, der ausreichend niedrig ist, um eine Ableitung der Wärme zu ermöglichen, die in den Momenten der Erzeugung der Prüfwechselhochspannung erzeugt wird, wobei jede reduzierte Spannungsperiode für die Analyse der Messungen in Bezug auf die Schritte 2 bis 7 von Anspruch 1 verwendet wird, und somit in der Lage ist, eine gepulste Zustandsleistung zuzuführen, die viel größer ist als die stationäre Nennleistung des Generators, während gleichzeitig die bei der Prüfung benötigte Blindleistung mittels einer Leistungselektronik vom Typ FACT kompensiert wird, um die Verwendung von Drosseln und Kondensatoren zum Kompensieren der bei der Prüfung benötigten Blindleistung zu begrenzen.

## Revendications

**1.** Méthode pour procéder en temps réel à des tests et à un diagnostic de sources de décharges partielles, ou DP, produites dans un matériel ou une installation à haute tension, qu'ils soient en fonctionnement ou non, en discriminant le bruit de fond, en identifiant la position des DP, en faisant la distinction entre différentes sources de DP situées dans une même position, en déterminant pour chaque source de DP son amplitude, taux de répétition et type de défaut associé, **caractérisé en ce que** la méthode comprend les étapes suivantes :

- à l'étape 1, effectuer une capture et une numérisation synchronisées de signaux analogiques respectivement collectés par deux capteurs DP appartenant à deux systèmes de mesure et étant chacun situés aux extrémités respectives de l'installation, à diagnostiquer conjointement avec des signaux analogiques collectés par deux capteurs de tension, un premier destiné à détecter une tension d'onde sinusoïdale test et un autre destiné à détecter une tension de réseau, toutes lesdites captures de signal débutant à l'instant où le TUC, ou Temps Universel Coordonné, coïncide avec une seconde exacte, étant supporté à cet effet sur, par exemple, un signal IPS, ou impulsion par seconde, délivré par un récepteur GPS, et chaque capture de signal ayant une période globale couvrant une ou plusieurs périodes complètes de l'onde de tension test ;
- à l'étape 2, segmenter les signaux capturés et numérisés en intervalles de temps équivalents aux périodes du signal de tension d'onde sinusoïdale test ;
- à l'étape 3, discriminer en temps réel, grâce à l'utilisation de multiprocesseurs, au sein du signal mesuré par chaque capteur DP capturé à l'étape 1, entre le bruit électrique de fond et la forme d'onde transitoire caractéristique du signal de type décharge partielle, ou type DP, en appliquant une transformée en ondelettes avec un traitement statistique du signal mesuré ;
- à l'étape 4, déterminer pour chaque signal de type DP, l'instant temporel, $t_i$, auquel il survient sur la référence temporelle TUC absolue, associé à la différence de phase du signal de type DP par rapport au passage par zéro du l'onde de tension test, $\varphi_i$, et par rapport au passage par zéro de l'onde de tension de réseau, ($p_{ri}$, dans le cas où la tension de réseau est différence de la tension test; ainsi que déterminer en temps réel, grâce à l'utilisation desdits multiprocesseurs, pour chaque i-ème signal de type DP, caractérisé comme un événement oscillant amorti, les paramètres de la fonction mathématique dite sécante hyperbolique asymétrique

$$e_i(t) = \frac{A_i}{e^{\alpha_i \cdot (t - t_{0i})} + e^{-\beta_i \cdot (t - t_{0i})}}$$

où :

- t est la variable temps;
- toi est le déplacement temporel de la fonction sécante hyperbolique asymétrique associée à la i-ème impulsion;
- ei(t) est la fonction sécante hyperbolique associée à la i-ième impulsion qui est asymétrique, lorsque les paramètres αi et βi sont différents ;
- Ai est le paramètre directement corrélé à l'amplitude maximale de l'onde enveloppe ; et
- αi et βi sont les paramètres de forme corrélés au temps de montée et au temps de descente de l'onde enveloppe,

qui s'adapte le mieux à l'enveloppe de l'événement oscillant amorti caractérisant le signal de type DP et extrayant de cette fonction ajustée les deux paramètres αi et βi représentatifs de la forme de l'enveloppe, respectivement en relation avec le temps de montée et le temps de descente du signal, qui sont associés aux deux coefficients αi et βi du dénominateur de la fonction sécante hyperbolique asymétrique ; ainsi que déterminer en temps réel, grâce à l'utilisation desdits multiprocesseurs, pour chaque signal de type DP, les paramètres de la fonction sinusoïdale

$$g_i(t) = sine(\omega_i \cdot t - \psi_i)$$

où :

- gi(t) est la fonction sinusoïdale associée à la i-ième impulsion ayant une fréquence fi (= $\omega$i/$2\pi$) décalée de $\varphi$i radians pour l'instant t=0 ;
- $\omega$i est la pulsation de l'onde sinusoïdale associée à la i-ème impulsion ;
- $\Psi$i est le déplacement angulaire de l'onde sinusoïdale associée à la i-ème impulsion pour t=0 ;

qui correspond le mieux à l'oscillation dudit événement oscillant amorti caractérisant le signal de type DP ; extrayant de cette fonction ajustée les paramètres de la fréquence fondamentale fi =$\omega$i /$2\pi$ en tant que paramètre représentatif de forme supplémentaire ;

- à l'étape 5, stocker les paramètres calculés caractéristiques de chaque impulsion de décharge partielle déterminée à l'étape 4 ;
- à l'étape 6, répéter les étapes 2 à 5 pour chaque intervalle de période de la tension de test de la période globale du signal DP capturé à l'étape 1 ;
- à l'étape 7, effectuer de nouvelles captures dans le but de répéter les étapes précédentes 2 à 6 suffisamment de fois pour permettre de disposer de données statistiquement suffisantes pour déterminer de manière fiable la position des sources DP, le nombre de sources DP différentes situées dans chaque position et les paramètres représentatifs de chaque source DP, qui correspondent à l'amplitude de cette décharge, au taux de répétition des impulsions DP et aux modèles résolus en phase de la tension test et de la tension du réseau ; le nombre d'acquisitions jugé suffisant pour le calcul mentionné étant de 250 périodes de l'onde de tension du réseau ;
- à l'étape 8, exclure les DP provenant de la tension de réseau loin du matériel testé, lorsque la tension de réseau est différente de la tension test, en représentant l'amplitude du DP résolu en phase de la tension de réseau cp(i) déterminé à l'étape 4;
- à l'étape 9, corréler lesdits paramètres caractéristiques de chaque signal DP mesuré avec les deux systèmes de mesure pour permettre de déterminer la position des sources DP en utilisant la référence temporelle absolue obtenue à l'étape 4 ;
- à l'étape 10, déterminer la carte de position des sources DP en tenant compte du retard d'arrivée des impulsions DP à chaque capteur mesuré avec un système de mesure différent et apparié par proximité, $x_i$ ($\Delta t_i$), en tenant compte du retard maximum possible entre les impulsions DP reçues par les deux systèmes de mesure, le rapport entre la longueur maximale que doit parcourir l'impulsion DP et la vitesse de propagation de l'impulsion DP ;

- à l'étape 11, identifier le nombre de sources DP différentes pour chaque position de sources DP par formation de groupes de signaux DP présentant des valeurs similaires pour les trois paramètres suivants obtenus à l'étape 4 : les deux paramètres représentatifs de la forme de l'enveloppe du signal de type DP, lié au temps de montée et au temps de descente, à savoir $\alpha_i$ et $\beta_i$, et le paramètre de la fréquence fondamentale $f_i$ de l'impulsion d'oscillation amortie caractéristique du signal DP ;

- à l'étape 12, déterminer pour chaque source DP une valeur représentative de l'amplitude de décharge, du taux de répétition des impulsions DP associé à chaque seconde d'acquisition, ainsi que le motif résolu en phase des impulsions DP de la tension d'onde test, la corrélant par rapport à des modèles de référence de défauts typiques, par exemple au moyen d'une structure de réseau neuronal entraînée dans des modèles de défauts typiques connus ;

- à l'étape 13, stocker les paramètres déterminés aux étapes 10 à 12 ;

- à l'étape 14, répéter le processus de détermination des paramètres calculés à l'étape 12 pour chaque source DP ;

- à l'étape 15, répéter le processus indiqué aux étapes 11 à 14 pour les sources DP associées à chaque position DP ;

- à l'étape 16, représenter graphiquement les résultats des étapes 10 à 12, correspondant à la carte de position des DP où se trouvent les sources DP, telle que déterminée à l'étape 10, aux groupes de différentes sources DP situés dans chaque position, comme identifiés à l'étape 11, et aux résultats obtenus pour chaque source DP, tels que déterminés à l'étape 12, correspondant à l'amplitude de la décharge, au taux de répétition, aux modèles résolus en phase des DP de la tension test et au résultat du type de défaut associé à chaque source DP du réseau.

2. Système physique pour détecter des signaux de type décharge partielle, ou type DP, pour la mise en oeuvre de la méthode selon la revendication 1, qui permet d'effectuer des mesures simultanées et synchronisées dans les deux systèmes de mesure de DP, en discriminant le bruit par rapport au caractéristique de forme d'onde transitoire des signaux DP, déterminer les paramètres associés à chaque DP, déterminer la carte de DP le long d'un câble selon l'étape 10, représenter graphiquement les groupes de sources de DP, représenter graphiquement les résultats de l'analyse, ledit système physique étant constitué des deux systèmes de mesure indépendants, chacun comportant les éléments suivants:

- un capteur de décharge partielle ;
- un capteur de tension pour mesurer la forme d'onde de la tension test ;
- un capteur de tension pour mesurer la forme d'onde de la tension de réseau dans le cas où elle est différente de la tension test ;
- une carte pour recevoir le signal temporel TUC, provenant par exemple d'un système GPS, et une autre carte de génération d'impulsions de déclenchement synchronisées, ou GID ;
- un enregistreur numérique déclenché par l'impulsion de synchronisation issue de la carte d'impulsions de déclenchement synchronisées ;
- un équipement de protection et de contrôle, protégeant contre les surtensions chaque enregistreur numérique du système de mesure;
- un ordinateur personnel à capacités de traitement multiples au travers d'une ou plusieurs unités multitraitements ;
- un ordinateur portable permettant de contrôler à distance le système de mesure.

3. Système physique selon la revendication 2, pour générer en outre des hautes tensions alternatives de la fréquence de la tension d'alimentation, par exemple 50 Hz ou 60 Hz, caractérisé ce que le système est configuré de manière à générer la haute tension alternative test pendant de courtes périodes de temps, au cours desquelles les signaux DP sont capturés selon étape 1 de la revendication 1 ; le système étant configuré de manière à réduire la tension, pendant une période d'attente, plus longue que la période pendant laquelle la haute tension alternative test est générée, jusqu'à une valeur suffisamment basse pour permettre la dissipation de la chaleur produite dans les moments de génération de haute tension alternative test, en utilisant chaque période de tension réduite pour analyser les mesures relatives aux étapes 2 à 7 de la revendication 1 et pouvoir ainsi fournir une puissance pulsée très supérieure à la puissance nominale en régime permanent du générateur, pendant que la puissance réactive nécessaire au test est simultanément compensée au moyen d'une électronique de puissance de type FACT afin de limiter l'utilisation de réacteurs et de condensateurs pour compenser la puissance réactive nécessaire à l'essai.

FIGURE 1

**EP 2 579 056 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1094324 A2